Europäisches Patentamt

European Patent Office

Office européen des brevets

(19)

(11) Veröffentlichungsnummer : **0 093 899**
B1

(12)　　　**EUROPÄISCHE PATENTSCHRIFT**

(45) Veröffentlichungstag der Patentschrift :
30.12.86

(21) Anmeldenummer : 83103728.8

(22) Anmeldetag : 18.04.83

(51) Int. Cl.⁴ : **G 01 R 31/28**

(54) **Anordnung zur Anpassung einer Prüfeinrichtung an einen Prüfling.**

(30) Priorität : 22.04.82 DE 3215074

(43) Veröffentlichungstag der Anmeldung :
16.11.83 Patentblatt 83/46

(45) Bekanntmachung des Hinweises auf die Patenterteilung : 30.12.86 Patentblatt 86/52

(84) Benannte Vertragsstaaten :
FR GB IT

(56) Entgegenhaltungen :
US-A- 4 092 589
IBM TECHNICAL DISCLOSURE BULLETIN, Band 23, Nr. 5, Oktober 1980 H.M.BUETTNER et al. "High speed logic/memory tester", Seiten 2030-2031
ELECTRONICS, 15. Dezember 1981 J. PRANG "Board testing meets the challenges of ECL", Seiten 146-150.

(73) Patentinhaber : **Siemens Aktiengesellschaft Berlin und München**
**Wittelsbacherplatz 2**
**D-8000 München 2 (DE)**

(72) Erfinder : **Welzhofer, Klaus**
**Ruffini-Allee 30**
**D-8032 Gräfelfing (DE)**

Anmerkung : Innerhalb von neun Monaten nach der Bekanntmachung des Hinweises auf die Erteilung des europäischen Patents im Europäischen Patentblatt kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

EP 0 093 899 B1

## Beschreibung

Die Erfindung bezieht sich auf eine Anordnung zur Anpassung einer Prüfeinrichtung an einen Prüfling, für den der zeitliche Versatz der von der Prüfeinrichtung zu erzeugenden Prüfsignale kleiner sein muß als der zeitliche Versatz der von der Prüfeinrichtung tatsächlich erzeugten Prüfsignale und bei der die Prüfsignale bzw. die daraufhin vom Prüfling abgegebenen Antwortsignale über einen Prüfstift der Prüfeinrichtung geführt werden.

Aus der DE-OS 29 51 929 ist eine Prüfeinrichtung bekannt, die einen Sender und einen Empfänger enthält. Der Sender erzeugt ein Prüfsignal, das einem Prüfling, z. B. einer Flachbaugruppe, zugeführt wird. Daraufhin gibt der Prüfling ein Antwortsignal ab, das vom Aufbau des Prüflings abhängt. Das Antwortsignal wird dem Empfänger in der Prüfeinrichtung zugeführt, der es auswertet. Sowohl die Prüfsignale als auch die Antwortsignale werden über denselben Prüfstift der Prüfeinrichtung zum Prüfling geführt.

Die von der Prüfeinrichtung erzeugten Prüfsignale weisen gewöhnlich einen zeitlichen Versatz auf, der vom Aufbau der Prüfeinrichtung abhängt. Das heißt die Prüfsignale werden nicht immer zum selben Zeitpunkt erzeugt, sondern deren Auftreten schwankt um den Sollauftrittszeitpunkt. Werden mit Hilfe einer solchen Prüfeinrichtung z. B. Flachbaugruppen geprüft, die Bausteine in TTL, MOS oder ECL Technik enthalten, muß die Prüfeinrichtung einen zeitlichen Versatz der Prüfsignale erreichen, der $\leq \pm 10$ ns ist. Dementsprechend muß die Prüfeinrichtung entworfen werden.

Soll eine derartige Prüfeinrichtung zur Prüfung von Prüflingen verwendet werden, die einen kleineren zeitlichen Versatz erforderlich machen, z. B. $\leq \pm 100$ ps, dann müßte die Prüfeinrichtung im Gesamten geändert werden.

Die der Erfindung zugrundeliegende Aufgabe besteht darin, eine Anordnung anzugeben, die eine bestehende Prüfeinrichtung mit einem festgelegten zeitlichen versatz der Prüfsignale an einen Prüfling anpaßt, bei dessen Prüfung ein kleinerer zeitlicher Versatz der Prüfsignale erforderlich ist. Diese Aufgabe wird bei einer Anordnung der eingangs angegebenen Art dadurch gelöst, daß zwischen dem Prüfstift und dem Ein-/Ausgang des Prüflings in antiparalleler Schaltung ein Sender und ein Empfänger angeordnet ist, die abwechselnd einschaltbar sind, daß an den Sender ein zweites Taktsignal anlegbar ist, dessen Auftreten das am Eingang des Senders anliegende Prüfsignal zum Ausgang durchschaltet, daß an den Empfänger ein drittes Taktsignal anlegbar ist, dessen Auftreten das am Eingang anliegende Antwortsignal bei Überschreiten einer Referenzspannung zum Ausgang durchschaltet, und daß eine Verzögerungsschaltung vorgesehen ist, der ein erstes Taktsignal zugeführt wird und die das zweite und dritte Taktsignal in einstellbaren Zeitabstanden erzeugt, welche Zeitabstände den gewünschten kleineren zeitlichen Versatz der Prüfsignale festlegen.

Sind der Sender bzw. Empfänger der Anordnung in ECL-Technik aufgebaut, dann kann die Einschaltanordnung für den Empfänger bzw. Sender aus einem Transistor bestehen, dessen Emitter mit dem Betriebspotentialanschluß der Ausgangsstufe des Senders/Empfängers verbunden ist, dessen Basisanschluß über eine Diode an einem ersten festen Potential liegt und eine Steuerspannung zwischen dem ersten Potential und einer den Transistor durchlässig steuernden Spannung zugeführt wird.

Um Tristate-Charakter des Empfängers/Senders zu erreichen, ist die als Emitterfolger aufgebaute Ausgangsstufe über einen Widerstand mit einem zweiten festen Potential verbunden.

Eine weitere Einschaltanordnung für Sender/Empfänger kann darin bestehen, daß jeweils am Ausgang des Senders und Empfängers ein NOR-Glied angeschlossen ist, dessen anderem Eingang ein Umschaltsignal direkt oder über einen Inverter zugeführt wird. Hier kann Tristate-Charakter dadurch erreicht werden, daß der andere Eingang des den Sender nachgeschalteten NOR-Gliedes über einen Widerstand mit einem festen Potential verbunden ist.

An Hand eines Ausführungsbeispiels, das in den Figuren dargestellt ist, wird die Erfindung weiter erläutert.

Es zeigen

Figur 1 ein Blockschaltbild der Prüfeinrichtung,

Figur 2 die zwischen der Prüfeinrichtung und dem Prüfling angeordnete erfindungsgemäße Anordnung,

Figur 3 ein Impulsdiagramm (Spannungen U aufgetragen über der Zeit t),

Figur 4 eine erste Anordnung zum Einschalten von Sender bzw. Empfänger,

Figur 5 eine weitere Anordnung zum Einschalten von Empfänger bzw. Sender.

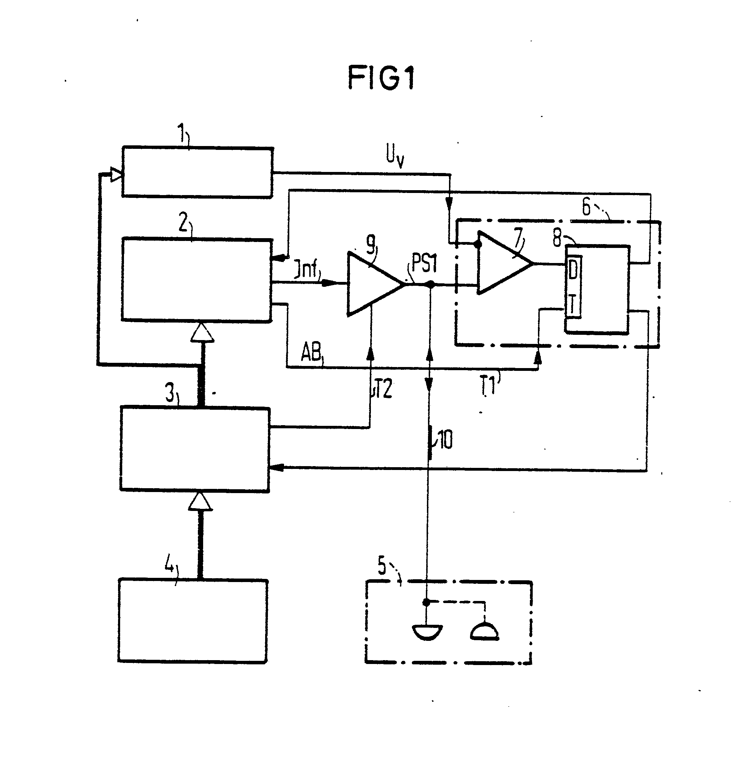

Eine Datenverarbeitungsanlage 4 wirkt auf eine Ablaufsteuerung 3 ein, die wiederum sowohl auf ein Zeitsteuerungsund Meßsystem 2 als auch auf einen Spannungsgeber 1 einwirkt. Der Spannungsgeber 1 liefert eine Vergleichsspannung UV für einen Empfänger 6, der in Fig. 1 aus einem Komparator 7 und einem Speicher 8, z. B. einem D-Flip-Flop besteht. Die Ausgänge des Empfängers 6 sind mit dem Zeitsteuerungs- und Meßsystem 2 und mit der Ablaufsteuerung 3 verbunden. Das Zeitsteuerungs- und Meßsystem 2 liefert außerdem einen Abtasttakt AB an den Speicher 8. In der Prüfeinrichtung ist weiterhin ein Sender 9 enthalten, der die Prüfsignale für einen Prüfling 5 erzeugt. Dazu werden dem Sender 9 von dem Zeitsteuerungs- und Meßsystem 2 Informationen INF zugeführt. Der Sender 9 erzeugt aus diesen Informationen INF in Abhängigkeit eines Taktsignales T2 die Prüfsignale PS1 am Ausgang. Der Ausgang des Senders 9 und der Eingang des Empfängers 6 ist mit einem Prüfstift 10 verbunden. An diesem Prüfstift 10 wird der Prüfling 5 angeschlossen. Der Prüfling 5 ist somit über eine bidirektionale Leitung mit der Prüfeinrichtung verbunden.

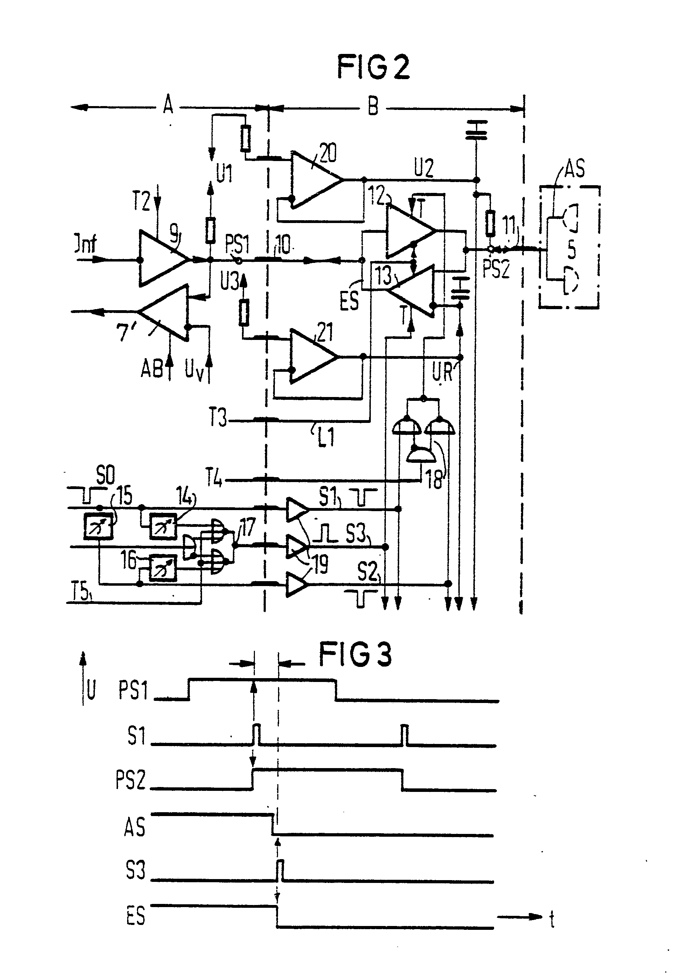

Der Sender 9 gibt die Prüfsignale PS1 ab, deren Flanken in Abhängigkeit vom Aufbau der Prüfeinrichtung einen zeitlichen Versatz von z. B. ≤ ± 10 ns aufweisen. Soll mit dieser Prüfeinrichtung ein Prüfling geprüft werden, der Prüfsignale mit kleinerem zeitlichen Versatz erfordert, dann muß zwischen der Prüfeinrichtung und dem Prüfling 5 eine Anordnung eingefügt werden, die den zeitlichen Versatz der Prüfsignale von der Prüfeinrichtung an den Prüfling anpaßt. Eine derartige Anordnung ergibt sich aus Fig. 2. Hier ist zwischen dem Prüfstift 10 und dem Prüfling 5 eine Anordnung B eingefügt, die den zeitlichen Versatz der Prüfsignale PS1 an den Prüfling 5 anpaßt. Diese Anordnung liegt zwischen der Ausgangsstufe A der Prüfeinrichtung und dem Prüfling 5. Über den Prüfstift 10 werden der Anordnung B von der Prüfeinrichtung A erste Prüfsignale PS1 zugeführt. Die Anordnung B erzeugt aus diesen ersten Prüfsignalen PS1 zweite Prüfsignale PS2, deren zeitlicher Versatz den gewünschten Wert hat. Diese Prüfsignale PS2 laufen über einen zweiten Prüfstift 11, an dem der Prüfling 5 angeschlossen ist.

Die vom Prüfling 5 auf die zweiten Prüfsignale PS2 abgegebenen Antwortsignale AS laufen ebenfalls über den Prüfstift 11 zur Anordnung B, die die Antwortsignale auswertet. Ein Ergebnissignal ES wird dann von der Anordnung B über den Prüfstift 10 der Prüfeinrichtung A zugeführt.

Im Ausführungsbeispiel der Fig. 2 besteht die Ausgangsstufe der Prüfeinrichtung A aus einem Sender 9 und einem Empfänger 7' bekannten Aufbaus. Deren Aufbau ergibt sich z. B. aus der DE-OS-29 51 929.

Die Anordnung B enthält ebenfalls einen Sender 12 und einen Empfänger 13. Der Sender 12 und der Empfänger 13 sind antiparallel geschaltet und können abwechselnd eingeschaltet werden. Dazu wird dem Sender 12 bzw. Empfänger 13 ein Umschaltsignal T3 über eine Leitung L1 direkt bzw. invertiert zugeführt.

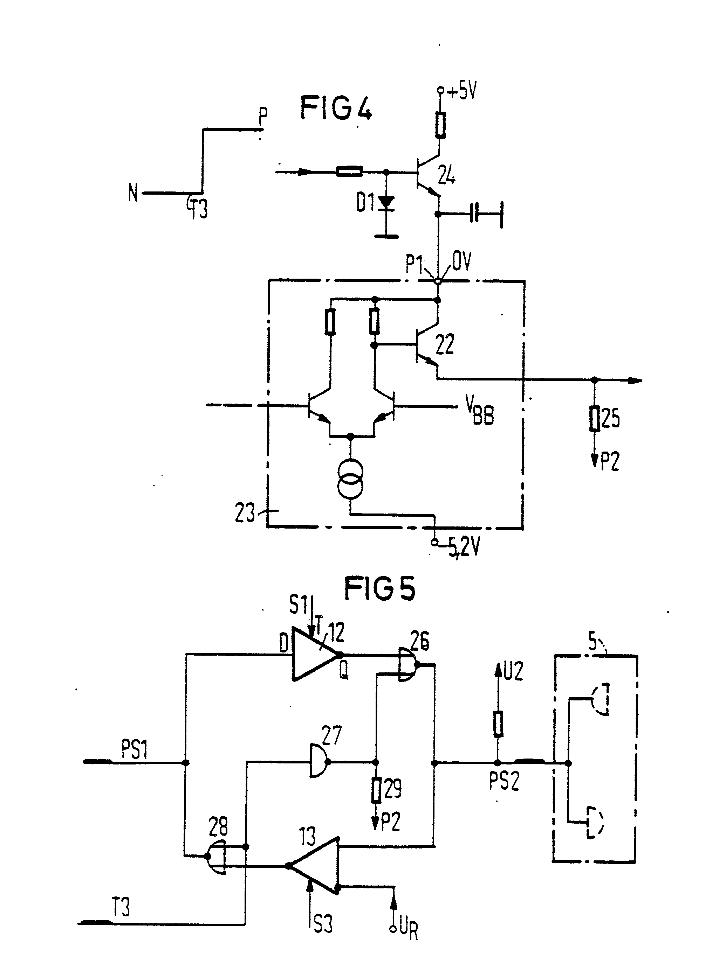

Die Erzeugung der zweiten Prüfsignale PS2 durch die Anordnung B erfolgt auf folgende Weise. Sollen die Prüfsignale erzeugt werden, dann wird der Sender 12 durch das Umschaltsignal T3 eingeschaltet. Das erste Prüfsignal PS1 wird an den Sender 12 angelegt (s. Fig. 3). Mit Hilfe eines Taktsignals S1 wird das erste Prüfsignal PS1 zum Ausgang des Senders 12 durchgeschaltet (Fig. 3). Am Ausgang des Senders 12 erscheint somit das zweite Prüfsignal PS2 zum Zeitpunkt des Auftretens des Taktsignals S1. Das Taktsignal S1 legt somit den Zeitpunkt des Auftretens des zweiten Prüfsignals PS2 fest und bestimmt auch, welchen zeitlichen Versatz die zweiten Prüfsignale PS2 haben.

Der Prüfling 5 erzeugt auf Grund des zweiten Prüfsignals PS2 ein Antwortsignal AS an einem anderen zweiten Prüfstift 11. Zu dessen Auswertung ist der Sender 12 an diesem anderen zweiten Prüfstift 11 abgeschaltet und der Empfänger 13 mit dem Umschaltsignal T3 eingeschaltet. Durch den Empfänger 13 wird das Antwortsignal AS mit einer Referenzspannung UR verglichen. Das sich durch den Vergleich ergebende Ergebnissignal ES wird aber erst dann zum Ausgang des Empfängers 13 durchgeschaltet, wenn ein Taktsignal S3 am Empfänger 13 anliegt. Das Ergebnissignal ES wird über den Prüfstift 10 der Prüfeinrichtung A zugeführt.

Sowohl der Sender 12 als auch der Empfänger 13 ist entsprechend dem Komparator 7 und dem Speicher 8 der Fig. 1 aufgebaut. Am Ausgang des Speichers 8 erscheint das zweite Prüfsignal PS2 bzw. das Ergebnissignal ES erst dann, wenn dem Speicher 8 das entsprechende Taktsignal S1 bzw. S3 zugeführt worden ist (am Eingang T).

Die Taktsignale S1, S3 können aus einem Taktsignal S0 mit Hilfe von Verzögerungseinrichtungen gewonnen werden. Derartige Verzögerungseinrichtungen können z. B. Verzögerungsleitungen sein. Das Taktsignal S0 wird z. B. direkt als Taktsignal S1 verwendet. Zusätzlich zu dem Taktsignal S1 kann noch ein Taktsignal S2 erzeugt werden, das ebenfalls dem Sender 12 zugeführt wird. Dazu wird das Taktsignal S0 über eine Verzögerungseinrichtung 15 geführt und als Taktsignal S2 verwendet. Mit Hilfe einer Umschalteinrichtung 18 kann entweder das Taktsignal S1 oder das Taktsignal S2 an den Sender 12 angelegt werden. Das Taktsignal S3 kann entweder direkt aus dem Taktsignal S0 gewonnen werden, wenn das Taktsignal S0 über eine Verzögerungseinrichtung 14 geführt wird. Es kann aber auch aus dem Taktsignal S2 gewonnen werden, wenn dieses über eine Verzögerungseinrichtung 16 geführt wird. Mit Hilfe einer Umschalteinrichtung 17 kann entweder das Ausgangssignal der Verzögerungseinrichtung 14 oder das Ausgangssignal der Verzögerungseinrichtung 16 als Taktsignal S3 verwendet werden. Am Ausgang der Verzögerungseinrichtungen sind jeweils Impulsformerstufen 19 angeordnet, die den Taktsignalen S1 bis S3 die gewünschte Form geben.

Die zum Betrieb der Anordnung B erforderlichen Betriebspotentiale werden der Prüfeinrichtung A entnommen. Dazu wird z. B. die Betriebsspannung U1 der Prüfeinrichtung A über einen Spannungsfolger 20 in die Betriebsspannung U2 umgewandelt, die für den Betrieb der Anordnung B erforderlich ist. Die Referenzspannung UR wird ebenfalls aus einer Betriebsspannung U3 der Prüfeinrichtung über einen Spannungsfolger 21 gewonnen.

Der zeitliche Abstand des Auftretens der Taktsignale S1/S2 und S3 wird mit Hilfe der Verzögerungseinrichtungen 14 bis 16 festgelegt. Wenn die Verzögerungszeit dieser Verzögerungseinrichtungen 14 bis 16 veränderbar ist, also z. B. Verzögerungsleitungen mit mehreren Abgriffen verwendet werden, kann der zeitliche Abstand des Auftretens der Taktsignale S1/S2 und S3 entsprechend verändert werden.

Mit Hilfe eines Taktsignals T4, das von der Prüfeinrichtung A geliefert wird, kann festgelegt werden, ob das Taktsignal S1 oder das Taktsignal S2 zum Sender 12 geschaltet wird. Mit Hilfe eines Taktsignals T5 von der Prüfeinrichtung A kann festgelegt werden, ob das Taktsignal S3 aus dem Taktsignal S0 direkt oder aus dem Taktsignal S2 gewonnen wird.

Mit Hilfe eines Umschaltesignals T3 auf der Leitung L1 kann entweder der Sender 12 oder der Empfänger 13 eingeschaltet werden. Dies kann mit Hilfe einer Schaltungsanordnung gemäß der Fig. 4 bzw. Fig. 5 erfolgen.

Bei der Schaltungsanordnung nach Fig. 4 ist Voraussetzung, daß die Ausgangsstufe des Senders 12 bzw. Empfängers 13 in ECL-Technik aufgebaut ist. Im strichlierten Raum der. Fig. 4 ist eine solche ECL-Ausgangsstufe bekannten Aufbaus dargestellt. Diese Ausgangsstufe enthält einen Emitterfolger 22. An diesem Emitterfolger 22 ist der ECL-Schaltkreis 23 in bekannter Weise angeschaltet. Zum Betrieb des ECL Schaltkreises ist ein festes Potential P1 von z. B. 0 Volt erforderlich. Soll der ECL-Schaltkreis 23 abgeschaltet werden, dann wird das Potential P1 auf z. B. — 0,8 V abgesenkt. Diese Absenkung wird durch einen Transistor 24, der in Emitterschaltung geschaltet ist, erreicht. Der Emitter des Transistors 24 ist somit mit dem Anschlußpunkt für das Betriebspotential P1 des ECL-Schaltkreises 23 verbunden. Der Basisanschluß des Transistors 24 ist über eine Diode D1 einerseits mit dem Betriebspotential am Punkt P1, z. B. 0 V, verbunden, andererseits wird ihm eine Steuerspannung T3 zugeführt. Hat diese ihren Wert P, z. B. von 4 V, dann ist die Diode D1 leitend gesteuert und an der Basis des Transistors 24 liegt ungefähr eine Spannung von 0,8 V. Am Emitter des Transistors 24 liegt dann 0 V und der ECL-Schaltkreis 23 erhält das richtige Betriebspotential. Hat die Steuerspannung T3 aber einen Wert N, z. B. OV, dann liegt am Emitter des Transistors 24 ca. — 0,8 V und der ECL-Schaltkreis 23 ist gesperrt. Am Ausgang des Emitterfolgers 22 liegt dann eine durch einen Widerstand 25 und ein Betriebspotential P2 festgelegte Spannung. Der Schaltkreis nach Fig. 4 hat somit Tristate-Charakter.

Fig. 5 zeigt eine andere Schaltungsanordnung, mit der zwischen Sender 12 und Empfänger 13 umgeschaltet werden kann. Am Ausgang des Senders 12 bzw. Empfängers 13 ist jeweils ein NOR-Glied 26 bzw. 28 angeordnet. Das Umschaltesignal T3 liegt an dem NOR-Glied 28 direkt, dagegen an dem NOR-Glied 26 über einen Inverter 27 an. Der Ausgang des Inverters 27 bzw. der entsprechende Eingang des NOR-Gliedes 26 ist weiterhin über einen Widerstand 29 mit einem Potential P2 verbunden. Mit Hilfe der NOR-Glieder 26, 28, dem Inverter 27 kann entweder der Sender 12 oder der Empfänger 13 eingeschaltet werden. Mit Hilfe zusätzlich des Widerstandes 29 und des Betriebspotentials P2 kann am Ausgang des Senders 12 Tristate-Charakter erreicht werden.

**Patentansprüche**

1. Anordnung zur Anpassung einer Prüfeinrichtung an einen Prüfling (5). für den der zeitliche Versatz der von der Prüfeinrichtung zu erzeugenden Prüfsignale kleiner sein muß als der zeitliche Versatz der von der Prüfeinrichtung tatsächlich erzeugten Prüfsignale und bei der die Prüfsignale bzw. die daraufhin vom Prüfling (5) abgegebenen Antwortsignale (AS) über einen Prüfstift (10) der Prüfeinrichtung geführt werden, dadurch gekennzeichnet, daß zwischen dem Prüfstift (10) und dem Ein-Ausgang des Prüflings (5) in antiparalleler Schaltung ein Sender (12) und ein Empfänger (13) angeordnet sind, die abwechselnd einschaltbar sind, daß an den Sender (12) ein zweites Taktsignal (S1/S2) anlegbar ist, dessen Auftreten das am Eingang des Senders anliegende erste Prüfsignal (PS1) als zweites Prüfsignal (PS2) zum Ausgang durchschaltet, daß an dem Empfänger (13) ein drittes Taktsignal (S3) anlegbar ist, dessen Auftreten das am Eingang anliegende Antwortsignal (AS) beim Überschreiten einer Referenzspannung (UR) zum Ausgang durchaltet, und daß eine Verzögerungseinrichtung (14, 15, 16) vorgesehen ist, der ein erstes Taktsignal (S0) zugeführt wird und die das zweite und dritte Taktsignal (S1/S2, S3) in einstellbaren Zeitabständen erzeugt, welche Zeitabstände den gewünschten kleineren zeitlichen Versatz der Prüfsignale festlegen (Fig. 2, 3).

2. Anordnung nach Anspruch 1, dadurch gekennzeichnet, daß die für den in ECL-Technik aufgebauten Sender bzw. Empfänger vorgesehene Einschaltanordnung besteht aus einem Transistor (24), dessen Emitter mit dem Betriebspotentialanschluß (P1) der Ausgangsstufe (23) des Senders/Empfängers (12/13) verbunden ist und dessen Basisanschluß über eine Diode (D1) an einem ersten festen Potential liegt und eine Steuerspannung (T3) zwischen dem ersten Potential (N) und einem den Transistor durchlässiger steuernden Potential (P) zugeführt wird (Fig. 4).

3. Anordnung nach Anspruch 2, dadurch gekennzeichnet, daß der Ausgang der als Emitterfolger (22) aufgebauten Ausgangsstufe (23) des Senders/Empfängers über einen Widerstand (25) mit einem zweiten Potential (P2) verbunden ist (Fig. 4).

4. Anordnung nach Anspruch 1, dadurch gekennzeichnet, daß jeweils am Ausgang des Senders (12) und Empfängers (13) ein NOR-Glied (26, 28) angeschlossen ist, dessen anderem Eingang ein Umschaltesignal (T3) direkt oder über einen Inverter (27) zugeführt wird (Fig. 5).

5. Anordnung nach Anspruch 4, dadurch gekennzeichnet, daß der andere Eingang des dem Sender (12) nachgeschalteten NOR-Gliedes (26) über einen Widerstand (29) mit einem festen Potential (P2) verbunden ist (Fig. 5).

**Claims**

1. An arrangement for matching a test device to a component (5) that is to be tested and for which the time displacement of the test signals must be smaller than the time displacement of the test signals actually produced by the test device, and where the test signals, and the response signals (AS) subsequently emitted from the component (5) are fed via a test pin (10) to the test device, characterised in that a transmitter (12) and a receiver (13) are arranged in anti-parallel fashion between the test pin (10) and the input-output of the component (5) and can be alternately connected, that the transmitter (12) can be supplied with a second clock signal (S1/S2), on the occurence of which the first test signal (AS) at the input of the transmitter, is switched through as a second test signal (PS2) to the output, that the receiver (13) can be supplied with a third clock signal (S3), on the occurrence of which the response signal (AS) occuring at the input is switched through to the output when a reference voltage (UR) is exceeded, and that a delay device (14, 15, 16) is provided, which is supplied with a first clock signal (S0) and produces the second and third clock signals (S1/S2, S3) at adjustable· time intervals which determine the desired smaller time displacement of the test signals. (Fig. 2, 3).

2. An arrangement as claimed in Claim 1, characterised in that the connection arrangement which is provided for the transmitter and receiver which are constructed in ECL technology consists of a transistor (24) whose emitter is connected to the operating potential terminal (P1) of the output stage (23) of the transmitter of the receiver (12/13) and whose base terminal is connected *via* diode (D1) to a first fixed potential and is supplied with a control voltage (T3) between the first potential (N) and a potential (P) which renders the transistor conductive. (Fig. 4).

3. An arrangement as claimed in Claim 2, characterised in that the output of the output stage (23) — which is constructed as an emitter-follower (22) — of the transmitter/receiver is connected *via* a resistor (25) to a second potential (P2). (Fig. 4).

4. An arrangement as claimed in Claim 1, characterised in that the output of the transmitter (12) and the receiver (13) are connected to a NOR-gate (26, 28), the other input of which is supplied with a switch-over signal (T3) either directly or *via* an inverter (27). (Fig. 5).

5. An arrangement as claimed in Claim 4, characterised in that the other input of the NOR-gate (26) which is connected to the output of the transmitter (12) is connected *via* a resistor (29) to a fixed potential (P2). (Fig. 5).

**Revendications**

1. Agencement pour adapter un dispositif de contrôle à un objet à tester (5), pour lequel le décalage temporel des signaux de contrôle devant être produits par le dispositif de contrôle doit être inférieur au décalage temporel des signaux de contrôle produits effectivement par le dispositif de contrôle, et dans lequel les signaux de contrôle ou les signaux de réponse (AS) délivrés à ces signaux de contrôle par l'objet à tester (5), sont envoyés par l'intermédiaire d'une pointe de contrôle (10) au dispositif de contrôle, caractérisé par le fait qu'entre la pointe de contrôle (10) et l'entrée-sortie de l'objet à tester (5) se trouvent disposés, selon un montage antiparallèle, un émetteur (12) et un récepteur (13), qui peuvent être branchés en alternance, qu'un second signal de cadence (S1/S2), dont l'apparition provoque la transmission directe, à la sortie, du premier signal de contrôle (PS1) appliqué à l'entrée de l'émetteur en tant que second signal de contrôle (PS2), peut être appliqué à l'émetteur (12), qu'un troisième signal de cadence (53), dont l'apparition provoque la transmission directe, à la sortie, du signal de réponse (AS) appliqué à l'entrée, lors du dépassement d'une tension de référence (UR), peut être appliqué au récepteur (13), et qu'il est prévu un dispositif de retardement (14, 15, 16) auquel un premier signal de cadence (S0) est envoyé et qui produit le second et le troisième signal de cadence (S1/S2, S3) à des intervalles de temps réglables qui déterminent le décalage temporel le plus faible désiré des signaux de contrôle (figures 2, 3).

2. Agencement suivant la revendication 1, caractérisé par le fait que le dispositif de branchement, qui est prévu pour l'émetteur et le récepteur réalisés suivant la technique ECL, est constitué par un transistor (24), dont l'émetteur est relié à la borne (P1) du potentiel de service de l'étage de sortie (23) de l'émetteur du récepteur (12/13) et dont la borne de base est placée par l'intermédiaire d'une diode (D1) à un premier potentiel fixe et qu'à cette borne de base se trouve appliquée une tension de commande (T3) se situant entre le premier potentiel (N) et un potentiel (P) plaçant le transistor à l'état passant (figure 4).

3. Agencement suivant la revendication 2, caractérisé par le fait que la sortie de l'étage de sortie (23), réalisé sous la forme d'un émetteur-suiveur (22) de l'émetteur du récepteur est reliée par l'intermédiaire d'une résistance (25) a un second potentiel (P2) (figure 4).

4. Agencement suivant la revendication 1, caractérisé par le fait qu'à la sortie de l'émetteur (12) et du récepteur (13) se trouve raccordé respectivement un circuit NON-OU (26, 28), à l'autre entrée duquel se trouve appliqué, directement ou par l'intermédiaire d'un inverseur (27), un signal de commutation (T3) (figure 5).

5. Agencement suivant la revendication 4, caractérisé par le fait que l'autre entrée·du circuit NON-OU (26), branché en aval de l'émetteur (12), est reliée par l'intermédiaire d'une résistance (29) à un potentiel fixe (P2) (figure 5).

# FIG 1

FIG 2

FIG 3

# FIG 4

# FIG 5